# EUROPEAN PATENT APPLICATION

(11) **EP 4 020 576 A1**
(43) Date of publication of application: **29.06.2022**
(21) Application number: 20861229.1
(22) Date of filing: 02.09.2020
(51) Int. Cl.: H01L 27/32

(54) **FLEXIBLE DISPLAY SCREEN, PREPARATION METHOD THEREFOR, AND ELECTRONIC DEVICE**

(30) Priority: 02.09.2019 CN 201910823881
(71) Applicant: Huawei Technologies Co., Ltd., Longgang District Shenzhen, Guangdong 518129 (CN)
(72) Inventor: ZHANG, Junyong, Shenzhen, Guangdong 518129 (CN); TIAN, Zheng, Shenzhen, Guangdong 518129 (CN)
(74) Representative: Körber, Martin Hans
(86) International application number: PCT/CN2020/112990
(87) International publication number: WO 2021/043159

(57) **Abstract**

Embodiments of this application provide a flexible display and a preparation method thereof, and an electronic device. The electronic device may include a mobile terminal or an immobile terminal with a flexible display, such as a mobile phone, a tablet computer, a notebook computer, an ultra-mobile personal computer (UMPC), a handheld computer, a walkie-talkie, a netbook, a POS terminal, a personal digital assistant (PDA), a wearable device, a virtual reality device, a wireless USB flash drive, a Bluetooth sounder/headset, or a car display. A first adjustment layer and a second adjustment layer are disposed between a touch film layer and a display panel, to reduce a stress on the touch film layer in a bending process, so that the touch film layer is not prone to an open circuit risk, thereby resolving a problem that a function of the display fails because the flexible display is prone to crack in the bending process.

## Description

This application claims priority to Chinese Patent Application No. 201910823881.X, filed with the Chinese Patent Office on September 2, 2019 and entitled "FLEXIBLE DISPLAY AND PREPARATION METHOD THEREOF, AND ELECTRONIC DEVICE", which is incorporated herein by reference in its entirety.

### TECHNICAL FIELD

This application relates to the field of terminal technologies, and in particular, to a flexible display and a preparation method thereof, and an electronic device.

### BACKGROUND

An organic light-emitting diode (Organic Light Emitting Diode, OLED) display panel has many advantages, for example, self-emits light, has a low drive voltage, high light-emitting efficiency, short response time, high definition and contrast, an angle of view of near 180°, and a wide use temperature range, and can implement flexible display and large-area full color display, and therefore is widely used in flexible displays in the industry.

Currently, when a flexible OLED display is used in a foldable electronic device, as shown in FIG. 1, the foldable electronic device includes a middle frame and a flexible display disposed on the middle frame. The middle frame includes a first middle frame 7a and a second middle frame 7b. The first middle frame 7a and the second middle frame 7b are rotatably connected by using a rotating member 6. The flexible display includes a display panel, a touch panel 3, a polarizer 2, and a cover 1. The display panel includes a backplane 5 and a display layer 4 disposed on the backplane 5. During folding, as shown in FIG. 2, the first middle frame 7a and the second middle frame 7b are folded, and the flexible OLED display is bent. As shown in FIG. 3, when the flexible OLED display is bent, each film layer in the flexible OLED display is bent.

However, in repeated bending processes of the flexible OLED display, the film layer in the display is prone to crack, causing a failure of a function of the display.

### SUMMARY

Embodiments of this application provide a flexible display and a preparation method thereof, and an electronic device, to reduce a risk that a touch layer cracks in a bending process of the flexible display, thereby increasing impact resistance capabilities of the flexible display in vertical and horizontal directions, and resolving a problem that a function of the display fails because the flexible display is prone to crack in the bending process.

A first aspect of the embodiments of this application provides a flexible display, including:
at least a display panel, a first adhesive layer, a first adjustment layer, a second adjustment layer, and a touch film layer that are laminated, where the first adhesive layer is located between the display panel and the first adjustment layer, and the second adjustment layer is located between the first adjustment layer and the touch film layer.

The first adjustment layer and the second adjustment layer serve as neutral layers for adjusting bending of the flexible display, to reduce a stress on the touch film layer during bending, so that the touch film layer is not prone to crack in a bending process. Furthermore, a matching degree of temperature and humidity deformation systems of upper and lower layers of the touch film layer may be adjusted by using the first adjustment layer and the second adjustment layer, to reduce a risk that the touch film layer cracks due to an internal stress when the touch film layer is bent at temperature and humidity. In addition, when the flexible display includes the first adjustment layer and the second adjustment layer, impact resistance capabilities of the flexible display are increased. In this way, after the flexible display is unfolded, the flexible display is not prone to crack in vertical and horizontal directions under a condition such as an external impact. Therefore, the first adjustment layer and the second adjustment layer are disposed, so that a problem that a function of the display fails because the flexible display is prone to crack in the bending process is resolved, and the impact resistance capabilities of the flexible display in the vertical and horizontal directions during unfolding are increased.

The first adjustment layer is a cyclo-olefin polymer COP layer, and the second adjustment layer is a glue layer. In this way, the second adjustment layer isolates a stress for the touch film layer, and fastens the touch film layer to the first adjustment layer.

In a possible implementation, a Young's modulus of the first adjustment layer is greater than a Young's modulus of the second adjustment layer.

In this way, a structure including a high Young's modulus layer and a low Young's modulus layer is added between the touch film layer and the display panel, to adjust a stress state of the touch film layer to match temperature and humidity coefficients of the upper and lower layers of the touch film layer, thereby improving structural strength of the flexible display.

In a possible implementation, the Young's modulus of the first adjustment layer is 2.0 GPa and the Young's modulus of the second adjustment layer is 80 to 800 kPa.

In a possible implementation, a thickness of the first adjustment layer is 20 to 40 µm.

In a possible implementation, a thickness of the second adjustment layer is 15 to 25 µm.

In a possible implementation, the glue layer is made of pressure sensitive adhesive PSA or optically clear adhesive OCA.

A second aspect of the embodiments of this application provides a flexible display, including:
at least a display panel, a first adhesive layer, and a touch film layer that are laminated, where the first adhesive layer is located between the touch film layer and the display panel.

In this way, when the flexible display is bent, the first adhesive layer isolates a stress, to reduce a stress on the touch film layer in a bending process, so that the touch film layer is not prone to an open circuit risk in the bending process. Therefore, in this embodiment of this application, the touch film layer is disposed on the first adhesive layer, and the first adhesive layer isolates the stress for the touch film layer. In this way, the touch film layer is not prone to an open circuit in the bending process, thereby ensuring normal use of the touch film layer.

In a possible implementation, the touch film layer includes a lift-off layer, a metal bridge layer disposed on the lift-off layer, a first insulation layer disposed on the lift-off layer and the metal bridge layer, a first touch electrode and a second touch electrode that cross and are insulated mutually and that are disposed on the first insulation layer, and a second insulation layer disposed on the first insulation layer, the first touch electrode, and the second touch electrode; and
one of the first touch electrode and the second touch electrode is disconnected at a cross position and connected by using the metal bridge layer.

In a possible implementation, the flexible display further includes a polarizer and a second adhesive layer, where the second adhesive layer is located between the polarizer and the touch film layer.

Screen brightness is increased by using the polarizer, and the polarizer is fastened to the touch film layer by using the second adhesive layer.

In a possible implementation, the flexible display further includes a protective layer and a third adhesive layer, where the third adhesive layer is located between the protective layer and the second adhesive layer.

In this way, the protective layer protects the flexible display.

A third aspect of the embodiments of this application provides an electronic device, including at least the flexible display according to either of the foregoing aspects, a middle frame, and a rear housing, where the middle frame is located between the flexible display and the rear housing.

The flexible display is included, so that when the electronic device is folded, a touch film layer in the flexible display is not prone to crack in a bending process. In addition, when the flexible display includes a first adjustment layer and a second adjustment layer, impact resistance capabilities of the flexible display are increased. In this way, after the flexible display is unfolded, the flexible display of the electronic device is not prone to crack in vertical and horizontal directions under a condition such as an external impact. Therefore, the first adjustment layer and the second adjustment layer are disposed in the flexible display, so that a problem that a function of the display fails because the flexible display is prone to crack in the bending process is resolved, and the impact resistance capabilities of the flexible display in the vertical and horizontal directions during unfolding are increased.

In a possible implementation, the electronic device is a foldable electronic device. In this way, the electronic device can be folded and unfolded for use. After the electronic device is folded, either of a main screen and a sub screen can be used for display. After the electronic device is unfolded, a larger display area can be provided.

In a possible implementation, the middle frame includes at least a first middle frame and a second middle frame, and the first middle frame and the second middle frame are rotatably connected by using a rotating member. In this way, the first middle frame and the second middle frame are rotatably connected, thereby ensuring that the electronic device can be folded and unfolded.

In a possible implementation, the flexible display is a rollable display with two ends rolled toward the rear housing. In this way, the electronic device is an electronic device with a rollable display, and disposition of the rollable display ensures that the electronic device has a high screen-to-body ratio.

A fourth aspect of the embodiments of this application provides a flexible display preparation method, where the method includes:
providing a touch film layer, a display panel, a first adjustment layer, a second adjustment layer, and an adhesive layer, where the first adjustment layer is a cyclo-olefin polymer COP layer, and the second adjustment layer is a glue layer;
disposing the second adjustment layer between the touch film layer and the first adjustment layer; and
disposing the adhesive layer between the first adjustment layer and a light-emitting surface of the display panel to form a flexible display.

The second adjustment layer is disposed between the touch film layer and the first adjustment layer, and the adhesive layer is disposed between the first adjustment layer and the light-emitting surface of the display panel. In this way, in the formed flexible display, there are the first adjustment layer and the second adjustment layer between the touch film layer and the display panel, and the first adjustment layer and the second adjustment layer serve as neutral layers for adjusting bending of the flexible display, to reduce a stress on the touch film layer during bending, so that the touch film layer is not prone to crack in a bending process. Furthermore, a matching degree of temperature and humidity deformation systems of upper and lower layers of the touch film layer may be adjusted by using the first adjustment layer and the second adjustment layer, to reduce a risk that the touch film layer cracks due to an internal stress when the touch film layer is bent at temperature and humidity. In addition, when the flexible display includes the first adjustment layer and the second adjustment layer, impact resistance capabilities of the flexible display are increased. In this way, after the flexible display is unfolded, the flexible display is not prone to crack in vertical and horizontal directions under a condition such as an external impact. Therefore, the first adjustment layer and the second adjustment layer are disposed, so that a problem that a function of the display fails because the flexible display is prone to crack in the bending process is resolved, and the impact resistance capabilities of the flexible display in the vertical and horizontal directions during unfolding are increased.

In a possible implementation, the providing a touch film layer includes:
forming a lift-off layer on a substrate;
forming a metal bridge layer on the lift-off layer;
disposing a first insulation layer on the lift-off layer and the metal bridge layer, and forming, in the first insulation layer, via holes each with one end electrically connected to the metal bridge layer;
forming, on the first insulation layer, a first touch electrode and a second touch electrode that cross and are insulated mutually, where one of the first touch electrode and the second touch electrode is disconnected at a cross position and connected to the metal bridge layer by using the via hole;
disposing a second insulation layer on the first touch electrode, the second touch electrode, and the first insulation layer; and
separating the substrate from the lift-off layer to form the touch film layer.

In this way, in the formed touch film layer, the lift-off layer in the touch film layer is in contact with the second adjustment layer, and a metal layer (for example, the metal bridge layer) in the touch film layer and the first adjustment layer are separated by the lift-off layer and the second adjustment layer, so that a stress on the first adjustment layer in the bending process is not prone to cause an open circuit of the metal layer in the touch film layer.

In a possible implementation, the disposing the second adjustment layer between the touch film layer and the first adjustment layer includes:
forming the second adjustment layer on the first adjustment layer; and
disposing the touch film layer on a surface that is of the second adjustment layer and that is opposite to the first adjustment layer.

In a possible implementation, the disposing the adhesive layer between the first adjustment layer and a light-emitting surface of the display panel includes:
forming the adhesive layer on the light-emitting surface of the display panel; and
adhering the first adjustment layer to the adhesive layer to form the flexible display; or
forming the adhesive layer on a surface that is of the first adjustment layer and that faces the display panel; and
adhering the light-emitting surface of the display panel to the adhesive layer to form the flexible display.

A fifth aspect of the embodiments of this application provides a flexible display preparation method, where the method includes:
providing a touch film layer, a display panel, and an adhesive layer; and
disposing the adhesive layer between the touch film layer and a light-emitting surface of the display panel to form a flexible display.

The adhesive layer is disposed between the touch film layer and the light-emitting surface of the display panel. In this way, in the formed flexible display, there is the adhesive layer between the touch film layer and the display panel, and the adhesive layer isolates a stress, to reduce a stress on the touch film layer in a bending process, so that the touch film layer is not prone to an open circuit risk in the bending process. Therefore, in this embodiment of this application, the adhesive layer isolates the stress for the touch film layer. In this way, the touch film layer is not prone to an open circuit in the bending process, thereby ensuring normal use of the touch film layer.

In a possible implementation, the providing a touch film layer includes:
forming a lift-off layer on a substrate;
forming a metal bridge layer on the lift-off layer;
disposing a first insulation layer on the lift-off layer and the metal bridge layer, and forming, in the first insulation layer, via holes each with one end electrically connected to the metal bridge layer;
forming, on the first insulation layer, a first touch electrode and a second touch electrode that cross and are insulated mutually, where one of the first touch electrode and the second touch electrode is disconnected at a cross position and connected to the metal bridge layer by using the via hole;
disposing a second insulation layer on the first touch electrode, the second touch electrode, and the first insulation layer; and
separating the substrate from the lift-off layer to form the touch film layer.

In this way, in the formed touch film layer, the lift-off layer in the touch film layer is in contact with the adhesive layer, and a metal layer (for example, the metal bridge layer) in the touch film layer and the display panel are separated by the lift-off layer and the adhesive layer. Therefore, the lift-off layer and the adhesive layer can isolate a stress for the metal layer in the touch film layer, so that the metal layer in the touch film layer is not prone to an open circuit in the bending process of the flexible display.

In a possible implementation, the disposing the adhesive layer between the touch film layer and a light-emitting surface of the display panel includes:
forming the adhesive layer on the light-emitting surface of the display panel; and
adhering the lift-off layer in the touch film layer to the adhesive layer to form the flexible display; or
forming the adhesive layer on a surface that is of the lift-off layer and that is opposite to the first insulation layer; and
adhering the light-emitting surface of the display panel to the adhesive layer to form the flexible display.

### BRIEF DESCRIPTION OF DRAWINGS

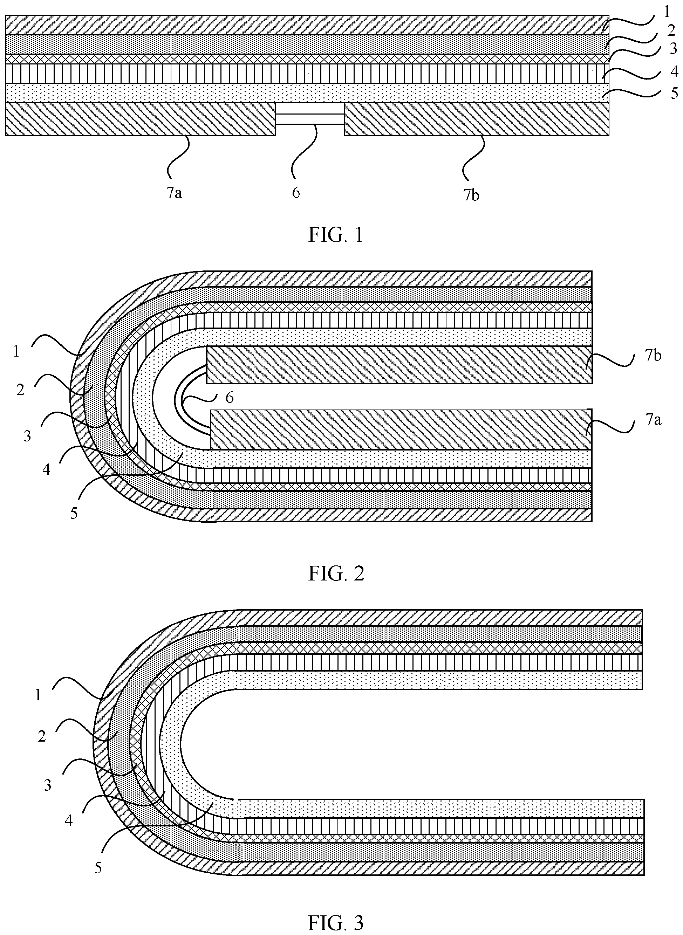

FIG. 1 is a schematic cross-sectional view of a middle frame and a display of an unfolded existing foldable mobile phone;
FIG. 2 is a schematic cross-sectional view of a middle frame and a display of a folded existing foldable mobile phone;
FIG. 3 is a schematic cross-sectional view of a display of a folded existing foldable mobile phone;

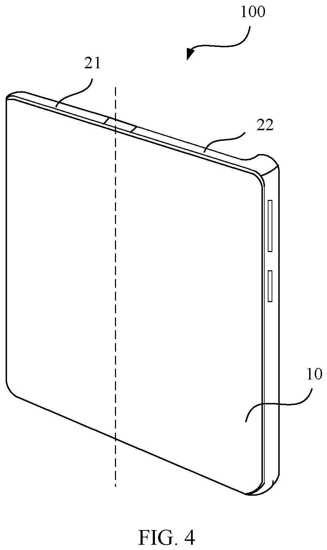

FIG. 4 is a schematic structural view of an unfolded electronic device according to an embodiment of this application;

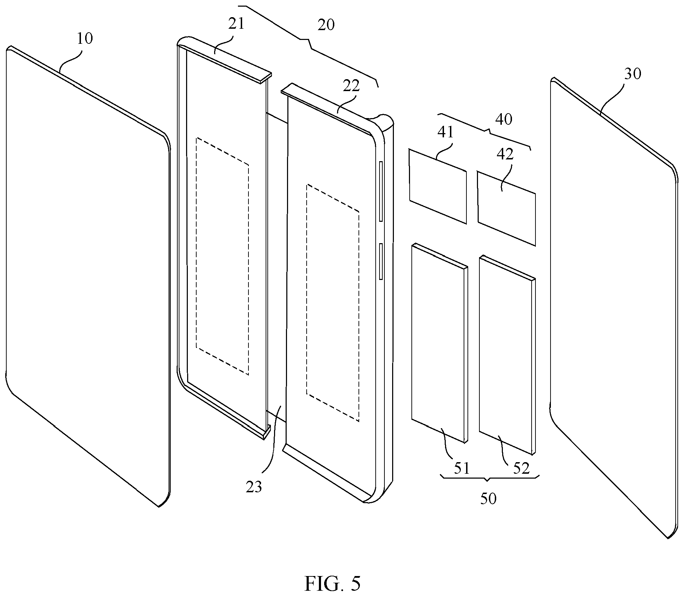

FIG. 5 is a schematic exploded view of an electronic device according to an embodiment of this application;

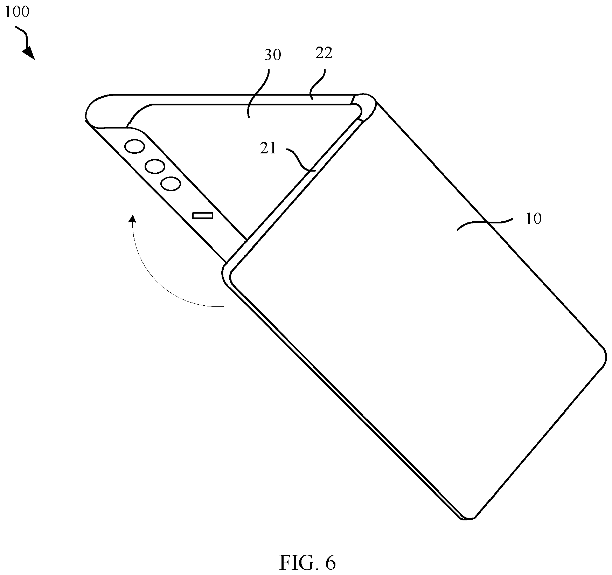

FIG. 6 is a schematic structural view of a bent electronic device according to an embodiment of this application;

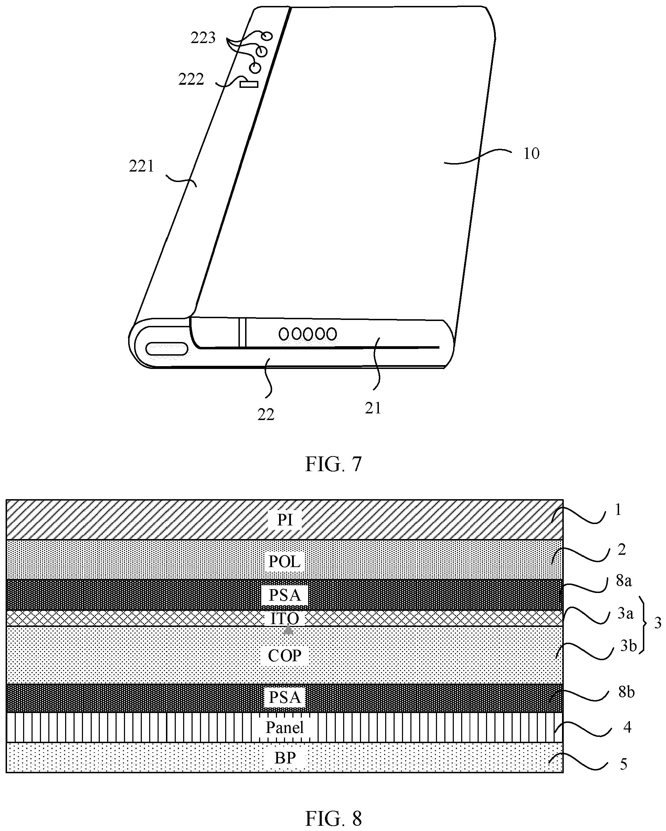

FIG. 7 is a schematic structural view of a folded electronic device according to an embodiment of this application;
FIG. 8 is a schematic cross-sectional structural view of an existing flexible display;

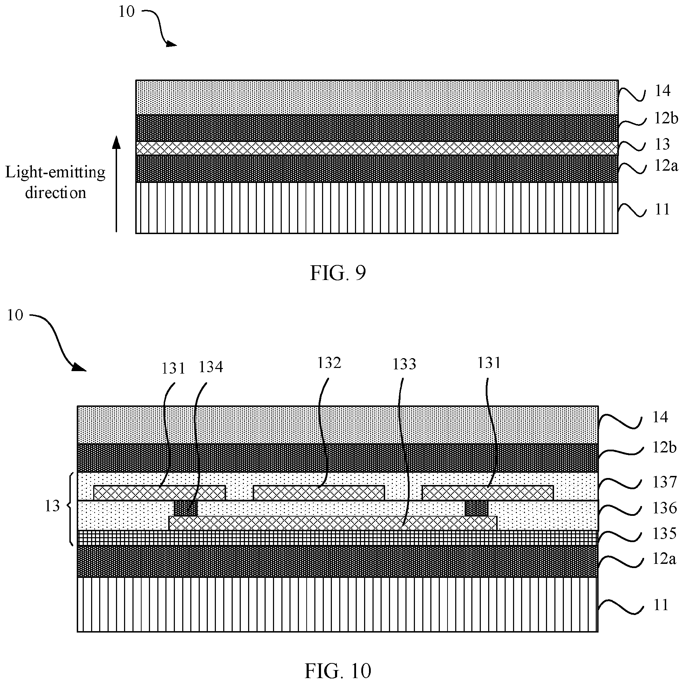

FIG. 9 is a schematic cross-sectional structural view of a flexible display of an electronic device according to an embodiment of this application;
FIG. 10 is another schematic cross-sectional structural view of a flexible display of an electronic device according to an embodiment of this application;

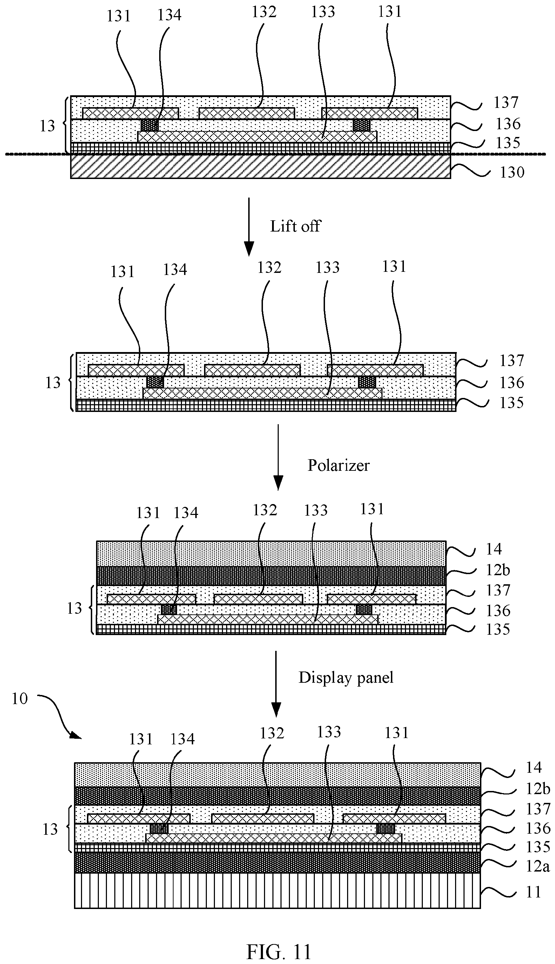

FIG. 11 is still another schematic cross-sectional structural view of a flexible display of an electronic device according to an embodiment of this application;

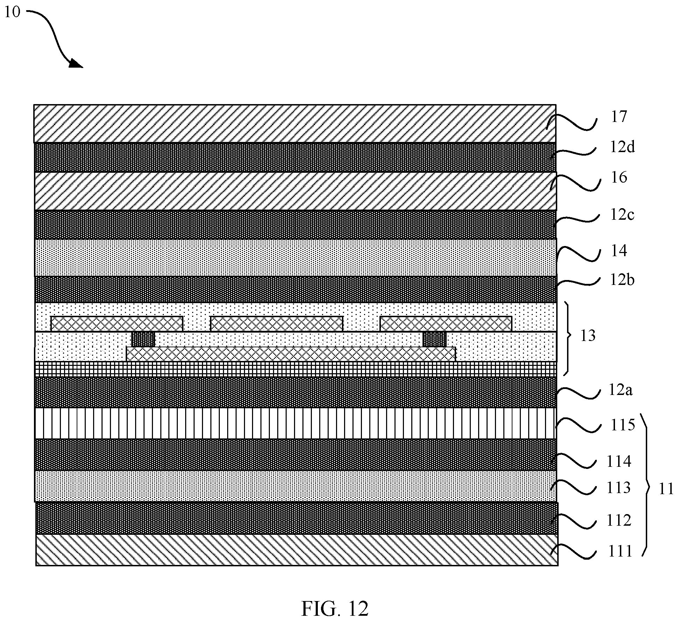

FIG. 12 is a schematic preparation view of a flexible display of an electronic device according to an embodiment of this application;

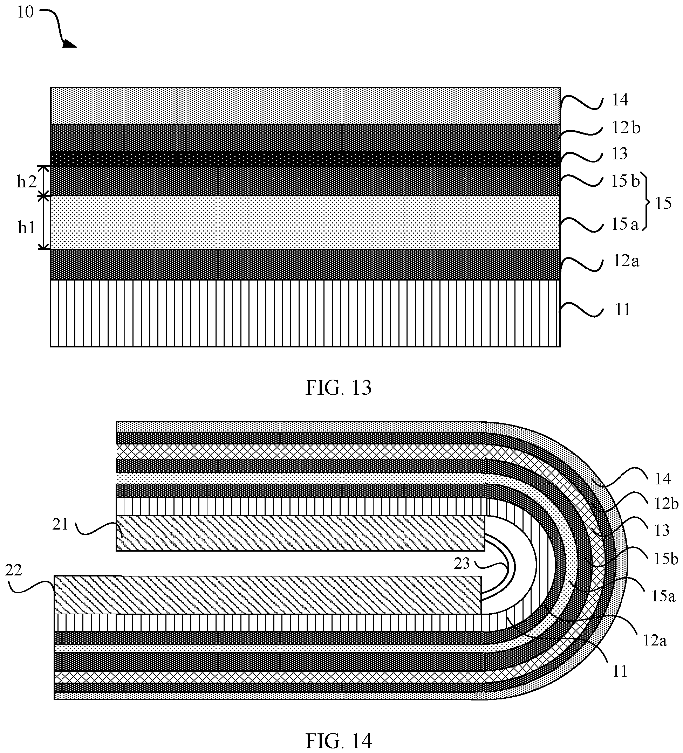

FIG. 13 is a schematic cross-sectional structural view of a flexible display of an electronic device according to an embodiment of this application;
FIG. 14 is a schematic cross-sectional structural view of a middle frame and a flexible display of a folded electronic device according to an embodiment of this application;

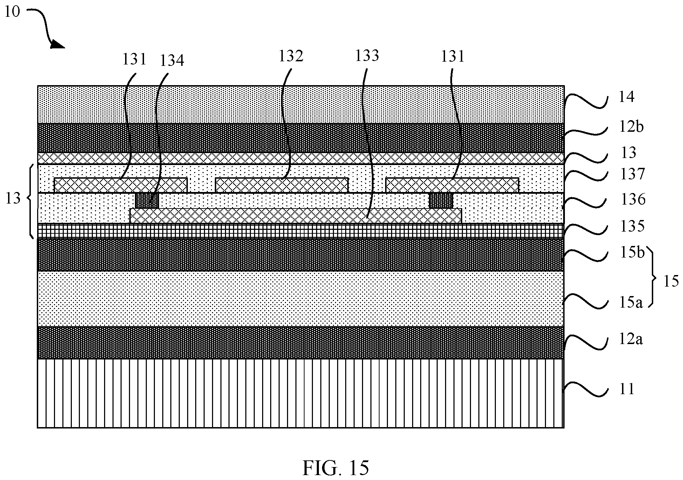

FIG. 15 is a schematic cross-sectional structural view of a flexible display of an electronic device according to an embodiment of this application;

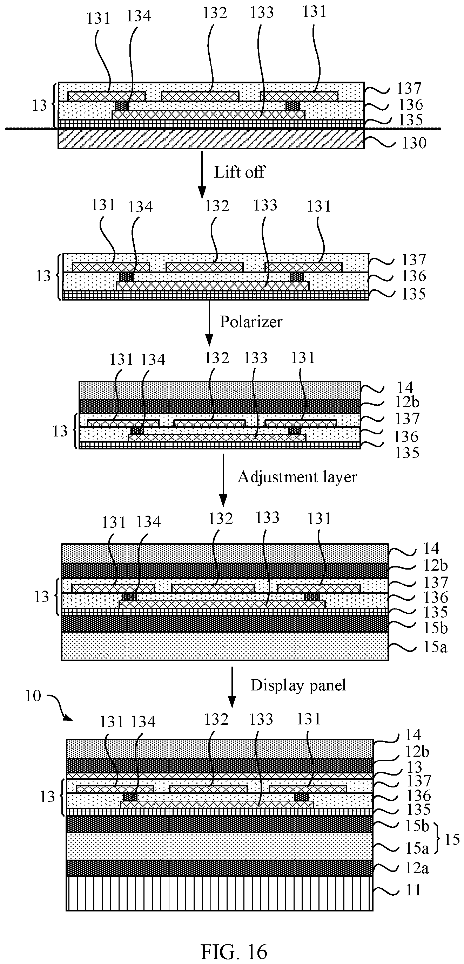

FIG. 16 is a schematic preparation view of a flexible display of an electronic device according to an embodiment of this application;

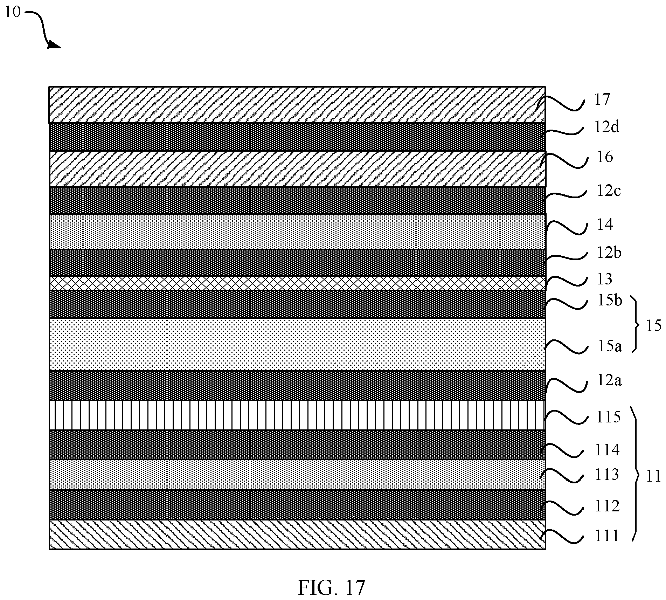

FIG. 17 is a schematic cross-sectional structural view of a flexible display of an electronic device according to an embodiment of this application;

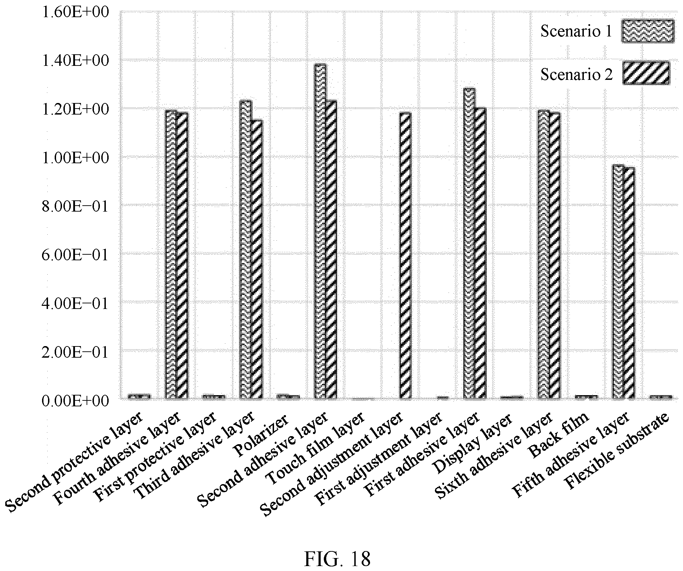

FIG. 18 is a schematic diagram of maximum principal strains of each film layer in a flexible display of an electronic device in two scenarios according to an embodiment of this application; and

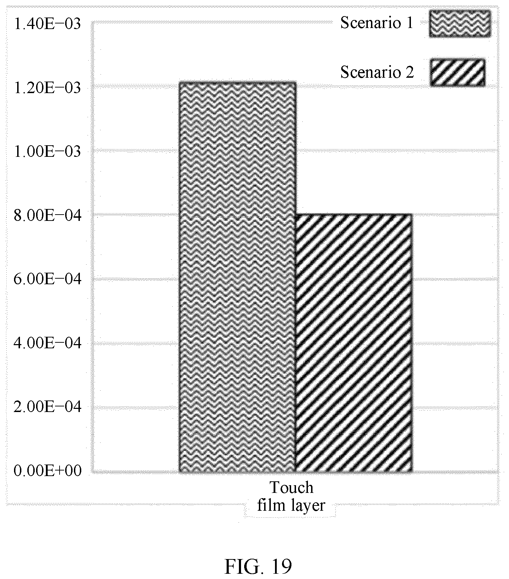

FIG. 19 is a schematic diagram of maximum principal strains of a touch layer in a flexible display of an electronic device in two scenarios according to an embodiment of this application.

Description of reference signs:
100-mobile phone; 10-flexible display; 11-display panel; 111-flexible substrate; 112-fifth adhesive layer; 113-back film; 114-sixth adhesive layer; 115-display layer; 12a-first adhesive layer; 12b-second adhesive layer; 12c-third adhesive layer; 12d-fourth adhesive layer; 13-touch film layer; 130-substrate; 131-first touch electrode; 132-second touch electrode; 133-metal bridge layer; 134-via hole; 135-lift-off layer; 136-first insulation layer; 137-second insulation layer; 14-polarizer; 15-adjustment layer; 15a-first adjustment layer; 15b-second adjustment layer; 16-first protective layer; 17-second protective layer; 20-middle frame; 21-first middle frame; 22-second middle frame; 221-end cover; 222-camera flash; 223-camera; 23-rotating member; 30-rear housing; 40-circuit board; 41-first circuit board; 42-second circuit board; 50-battery; 51-first battery; and 52-second battery.

### DESCRIPTION OF EMBODIMENTS

The terms used in the implementations of this application are merely used to explain specific embodiments of this application, and are not intended to limit this application. The following describes the implementations of the embodiments of this application in detail with reference to the accompanying drawings.

An electronic device provided in an embodiment of this application may include but is not limited to a mobile or an immobile terminal with a flexible display, such as a mobile phone, a tablet computer, a notebook computer, an ultra-mobile personal computer (ultra-mobile personal computer, UMPC), a handheld computer, a walkie-talkie, a netbook, a POS terminal, a personal digital assistant (personal digital assistant, PDA), a wearable device, a virtual reality device, or a car display.

This embodiment of this application provides description by using an example in which a mobile phone 100 is the electronic device. The mobile phone 100 provided in this embodiment of this application may be a foldable mobile phone, or may be a mobile phone with a rollable display, or may be another mobile phone with a bendable display. In this embodiment of this application, a foldable mobile phone 100 is used as an example. FIG. 4 shows an unfolded structure of the foldable mobile phone 100. Referring to FIG. 4, during folding, the mobile phone 100 may be folded along a broken line in FIG. 4. Referring to FIG. 4 and FIG. 5, the mobile phone 100 may include a flexible display 10, a middle frame 20, a circuit board 40, a battery 50, and a rear housing 30. When the mobile phone 100 is unfolded, the flexible display 10 and the rear housing 30 are separately located on two sides of the middle frame 20, and the circuit board 40 and the battery 50 may be located between the middle frame 20 and the rear housing 30 or the circuit board 40 and the battery 50 may be located between the middle frame 20 and the flexible display 10.

Referring to FIG. 5, the middle frame 20 may include a first middle frame 21 and a second middle frame 22. The first middle frame 21 and the second middle frame 22 are rotatably connected by using a rotating member 23 (for example, the rotating member 23 may be a rotating shaft, a hinge, or a flexible board). In this way, the first middle frame 21 and the second middle frame 22 in the mobile phone 100 can be folded and unfolded around the rotating member 23.

The first middle frame 21 and the second middle frame 22 may be metal middle frames. Alternatively, the first middle frame 21 and the second middle frame 22 may be middle frames made of two types of materials: ceramic and metal. For example, edges of the first middle frame 21 and the second middle frame 22 are ceramic edges, middle plates in the first middle frame 21 and the second middle frame 22 are metal middle plates, and the ceramic edges and the metal middle plates constitute the first middle frame 21 and the second middle frame 22. Certainly, materials of the first middle frame 21 and the second middle frame 22 include but are not limited to metal and ceramic, and may be alternatively other materials.

In this embodiment of this application, the first middle frame 21 and the second middle frame 22 may be folded horizontally along the broken line in FIG. 4. In another example, the first middle frame 21 and the second middle frame 22 may be alternatively folded vertically, folded diagonally, or folded at any other angle. It may be understood that the mobile phone 100 shown in FIG. 5 includes two middle frames 20: the first middle frame 21 and the second middle frame 22, to fold two displays of the mobile phone 100. In another example, the mobile phone 100 may alternatively include three middle frames, so that three displays of the mobile phone 100 can be folded. A quantity of foldable displays of the mobile phone 100 is specifically set based on an actual requirement.

In this embodiment of this application, one of the first middle frame 21 and the second middle frame 22 may be a middle frame corresponding to a main screen of the mobile phone 100, and the other may be a middle frame corresponding to a sub screen of the mobile phone 100. For example, the first middle frame 21 may be a main middle frame corresponding to the main screen, and the second middle frame 22 may be a sub middle frame corresponding to the sub screen. When the first middle frame 21 and the second middle frame 22 are folded, the main screen and the sub screen of the mobile phone 100 may face each other, or the main screen and the sub screen of the mobile phone 100 may be opposite to each other. In this embodiment of this application, after the first middle frame 21 and the second middle frame 22 are folded along the broken line in FIG. 4, the main screen and the sub screen of the mobile phone 100 are opposite to each other. In other words, after the mobile phone 100 is folded, both the front and the back of the mobile phone 100 are displays. In this case, a user may use the main screen for display, or may use the sub screen for display.

In this embodiment of this application, when the mobile phone 100 includes the first middle frame 21 and the second middle frame 22, the rear housing 30 may be a rear housing 30 shown in FIG. 5, and the rear housing 30 covers one side of the first middle frame 21 and the second middle frame 22. To fold the mobile phone 100, the rear housing 30 may be a flexible rear housing made of a flexible material. For example, the rear housing 30 is a bendable flexible glass rear housing, or the rear housing 30 is a bendable plastic rear housing.

In another example, the rear housing 30 may include a first rear housing and a second rear housing (not shown). For example, the first rear housing is located on one side of the first middle frame 21, and the second rear housing is located on one side of the second middle frame 22; in other words, one rear housing is correspondingly disposed for each of the two middle frames. A bendable flexible substrate is used between the first rear housing and the second rear housing. In this way, during folding, the first rear housing and the second rear housing are folded around the flexible substrate. When the rear housing 30 includes the first rear housing and the second rear housing, the first rear housing and the second rear housing may be metal rear housings, or the first rear housing and the second rear housing may be glass rear housings, or the first rear housing and the second rear housing may be ceramic rear housings. It should be noted that materials of the first rear housing and the second rear housing include but are not limited to metal, glass, or ceramic.

In this embodiment of this application, as shown in FIG. 5, the circuit board 40 may include a first circuit board 41 and a second circuit board 42. The first circuit board 41 and the second circuit board 42 may be electrically connected by using a flexible printed circuit (FPC). The first circuit board 41 may be located in the first middle frame 21, and the second circuit board 42 may be located in the second middle frame 22. One of the first circuit board 41 and the second circuit board 42 may be a main circuit board (namely, a mainboard), and the other may be a sub circuit board.

In this embodiment of this application, as shown in FIG. 5, the battery 50 may include a first battery 51 and a second battery 52. The first battery 51 may be located at a dashed-line position in the first middle frame 21 in FIG. 5, and the second battery 52 may be located at a dashed-line position in the second middle frame 22 in FIG. 5.

Certainly, disposition positions of the first battery 51 and the second battery 52 include but are not limited to the dashed-line positions in the first middle frame 21 and the second middle frame 22 in FIG. 5. The first battery 51 and the second battery 52 may be connected to a charging management module and the circuit board 40 by using a power management module. The power management module receives input from the battery 50 and/or the charging management module, and supplies power to a processor, an internal memory, an external memory, the flexible display 10, a camera, a communications module, and the like. The power management module may be further configured to monitor parameters such as a capacity of the battery 50, a cycle count of the battery 50, and a state of health (electric leakage and impedance) of the battery 50. In some other embodiments, the power management module may be disposed in the processor of the circuit board 40. In some other embodiments, the power management module and the charging management module may be alternatively disposed in a same component.

In this embodiment of this application, the flexible display 10 may be an OLED display. When the mobile phone 100 is folded, the flexible display 10 may be bent along an arrow direction in FIG. 6. After the folding, as shown in FIG. 7, the flexible display 10 is bent at one end of the first middle frame 21 and the second middle frame 22. In this embodiment of this application, an end that is of the second middle frame 22 and that is away from the first middle frame 21 has an end cover 221. After the first middle frame 21 and the second middle frame 22 are folded, a width of a display area on the first middle frame 21 is less than a width of a display area on the second middle frame 22. In other words, after the mobile phone 100 is folded, the two displays differ in size.

In this embodiment of this application, camera flashes 222 and a camera 223 may be disposed on the end cover 221. The end cover 221 may be fastened to the second middle frame 22 through clamping, welding, or integrated molding. The end cover 221 is disposed, so that the camera 223 and the camera flashes 222 can be disposed; and the user is not prone to contact with the display when holding the mobile phone 100, thereby facilitating the user in holding the mobile phone 100.

Usually, as shown in FIG. 8, a structure of the flexible display 10 may include a backplane 5, a display panel 4 disposed on the backplane 5, a touch panel 3, a polarizer 2, and a cover 1. The display panel 4 is connected to the touch panel 3 by using an adhesive layer 8b, and the touch panel 3 is connected to the polarizer 2 by using an adhesive layer 8a. As known to persons skilled in the art, the polarizer 2 is mainly used to increase screen brightness and is not necessary for display, and therefore can be omitted.

As shown in FIG. 8, a conventional touch panel 3 may include a support layer 3b and a touch layer 3a disposed on the support layer 3b. The support layer 3b in the touch panel 3 is connected to the display panel 4 by using the adhesive layer 8b, and the touch layer 3a in the touch panel 3 is connected to the polarizer 2 by using the adhesive layer 8a. When the flexible display is bent, each film layer is strained under the action of a stress at a bent part. Cyclo-olefin polymer (Cyclo-olefin Polymer, COP) is usually used as a material of the support layer 3b, and the COP material is relatively fragile. Therefore, a stress on the COP material in a bending process is prone to exceed a material limit, and consequently the support layer 3b is prone to crack. However, an electrode layer of the touch layer 3a is prone to an open circuit due to cracking of the support layer 3b (because a part of the electrode layer of the touch layer 3a is patterned on the support layer 3b), causing a failure of some areas of the touch layer 3a.

Based on the foregoing description, an embodiment of this application provides a flexible display 10, to reduce a risk that a touch layer in the flexible display 10 fails in a bending process.

The following describes a structure of the flexible display 10 in the foldable mobile phone 100 for the following scenarios.

### Scenario 1

Referring to FIG. 9, the flexible display 10 may include a display panel 11, a first adhesive layer 12a, a touch film layer 13, a second adhesive layer 12b, and a polarizer 14 that are laminated sequentially. The first adhesive layer 12a is disposed between the display panel 11 and the touch film layer 13, and the second adhesive layer 12b is disposed between the touch film layer 13 and the polarizer 14. For example, the first adhesive layer 12a is disposed on a light-emitting surface of the display panel 11, the touch film layer 13 is fastened to the light-emitting surface of the display panel 11 by using the first adhesive layer 12a, the second adhesive layer 12b is disposed on a surface that is of the touch film layer 13 and that faces the polarizer 14, and the polarizer 14 is fastened to the touch film layer 13 by using the second adhesive layer 12b. It should be noted that the light-emitting surface of the display panel 11 is a surface from which a light-emitting unit in the display panel 11 emits light. For example, in FIG. 9, the display panel 11 emits light upward, in other words, the display panel 11 is top light-emitting, and therefore the light-emitting surface of the display panel 11 is a top surface of the display panel 11.

In this embodiment of this application, the first adhesive layer 12a is disposed between the display panel 11 and the touch film layer 13. In this way, when the flexible display 10 is bent, the first adhesive layer 12a isolates a stress, to reduce a stress on the touch film layer 13 in a bending process, so that the touch film layer 13 is not prone to an open circuit risk in the bending process. Compared with the flexible display 10 in FIG. 8, in the flexible display 10 provided in this embodiment of this application, the support layer 3b in the touch panel is removed. In this way, an overall thickness of the flexible display 10 is reduced, and a risk that an open circuit occurs on the touch film layer 13 because the support layer 3b is prone to crack is eliminated. Therefore, in this embodiment of this application, the touch film layer 13 is disposed on the first adhesive layer 12a, and the first adhesive layer 12a isolates the stress for the touch film layer 13. In this way, the touch film layer 13 is not prone to an open circuit in the bending process, thereby ensuring normal use of the touch film layer 13.

In this embodiment of this application, materials of the first adhesive layer 12a and the second adhesive layer 12b may be pressure sensitive adhesive (Pressure Sensitive Adhesive, PSA). During disposition, pressure sensitive adhesive may be compressed into a thin film in advance, and then the thin film is attached to the light-emitting surface of the display panel 11. Alternatively, in this embodiment of this application, materials of the first adhesive layer 12a and the second adhesive layer 12b may be optically clear adhesive (Optically Clear Adhesive, OCA), and optically clear adhesive may be disposed on the light-emitting surface of the display panel 11 through coating.

It should be noted that, because pressure sensitive adhesive and optically clear adhesive are disposed on the display panel 11 in different manners, adhesive layers made of pressure sensitive adhesive and the optically clear adhesive differ in thickness. For example, when optically clear adhesive is used as the materials of the first adhesive layer 12a and the second adhesive layer 12b, the made adhesive layers each have a relatively large thickness; and when pressure sensitive adhesive is used as the materials of the first adhesive layer 12a and the second adhesive layer 12b, the made adhesive layers each have a relatively small thickness. In this embodiment of this application, pressure sensitive adhesive is used for the first adhesive layer 12a and the second adhesive layer 12b. In this way, it is ensured that the first adhesive layer 12a and the second adhesive layer 12b each have a relatively small thickness, thereby reducing the thickness of the flexible display 10.

In this embodiment of this application, when optically clear adhesive is used as the materials of the first adhesive layer 12a and the second adhesive layer 12b, a thickness of each of the made first adhesive layer 12a and second adhesive layer 12b may be 50 to 100 µm. When pressure sensitive adhesive is used as the materials of the first adhesive layer 12a and the second adhesive layer 12b, a thickness of each of the made first adhesive layer 12a and second adhesive layer 12b may be 15 to 25 µm. For example, the thickness of each of the first adhesive layer 12a and the second adhesive layer 12b may be 18 µm, or the thickness of each of the first adhesive layer 12a and the second adhesive layer 12b may be 23 µm.

For example, as shown in FIG. 10, the touch film layer 13 may include a lift-off layer 135 (Laser Lift-Off, LLO), a metal bridge layer 133 disposed on the lift-off layer 135, a first insulation layer 136 covering the lift-off layer 135 and the metal bridge layer 133, a first touch electrode 131 and a second touch electrode 132 that are patterned on the first insulation layer 136, and a second insulation layer 137 covering the first touch electrode 131, the second touch electrode 132, and the first insulation layer 136.

The first touch electrode 131 and the second touch electrode 132 cross, and the first touch electrode 131 and the second touch electrode 132 are insulated at a cross position. For example, one of the first touch electrode 131 and the second touch electrode 132 is disconnected at the cross position. As shown in FIG. 10, the first touch electrode 131 is disconnected at the cross position, and two disconnected ends of the first touch electrode 131 are both electrically connected to the metal bridge layer 133 by using via holes 134 disposed at the first insulation layer 136. In this way, two parts of the disconnected first touch electrode 131 are connected by using the metal bridge layer 133 and the via holes 134, so that the first touch electrode 131 and the second touch electrode 132 are insulated at the cross position.

It should be noted that, in this embodiment of this application, alternatively, the first touch electrode 131 and the second touch electrode 132 may be disposed on the lift-off layer 135, and the metal bridge layer 133 may be disposed on the first insulation layer 136. In this way, the metal bridge layer 133 is located above the first touch electrode 131 and the second touch electrode 132. In this embodiment of this application, a position at which the metal bridge layer 133 is disposed includes but is limited to the position shown in FIG. 10, provided that the metal bridge layer 133 can electrically connect two parts of a touch electrode disconnected at a cross position.

In this embodiment of this application, one of the first touch electrode 131 and the second touch electrode 132 may be a drive electrode (Tx), and the other may be a receive electrode (Rx). For example, the first touch electrode 131 may be a Tx, and the second touch electrode 132 may be an Rx.

In this embodiment of this application, the first touch electrode 131, the second touch electrode 132, and the metal bridge layer 133 may be made of metal materials. For example, the first touch electrode 131 and the second touch electrode 132 may be made of indium tin oxide (ITO) or may be made of indium zinc oxide (IZO), and a material of the metal bridge layer 133 may be copper metal or silver. A metal material of the via hole may be silver paste. The first insulation layer 136 and the second insulation layer 137 may be organic insulation layers. A material of the lift-off layer 135 may be polyimide (Polyimide, PI). It should be noted that materials of the first touch electrode 131, the second touch electrode 132, the metal bridge layer 133, the first insulation layer 136, the second insulation layer 137, and the lift-off layer 135 include but are not limited to the foregoing materials.

The material of the lift-off layer 135 may be polyimide (Polyimide, PI). In this way, the first adhesive layer 12a and the lift-off layer 135 are both organic film layers and therefore have a same attribute. Therefore, when the display panel 11 is adhered to the lift-off layer 135 in the touch film layer 13 by using the first adhesive layer 12a, an adhesive force between the first adhesive layer 12a and the lift-off layer 135 is greater, so that an adhesive force between the display panel 11 and the touch film layer 13 is greater, and the display panel 11 is not prone to lift off from the touch film layer 13 in the bending process.

When the second insulation layer 137 in the touch film layer 13 is an organic insulation layer, the polarizer 14 is adhered to the second insulation film layer in the touch film layer 13 by using the second adhesive layer 12b. The second insulation layer 137 and the second adhesive layer 12b are both organic film layers and therefore have a same attribute. Therefore, an adhesive force between the second adhesive layer 12b and the second insulation film layer is greater, so that an adhesive force between the polarizer 14 and the touch film layer 13 is greater, and the polarizer 14 is not prone to lift off from the touch film layer 13 in the bending process.

In this embodiment of this application, a thickness of the touch film layer 13 may be 6 to 15 µm. For example, the thickness of the touch film layer 13 may be 7 µm, or the thickness of the touch film layer 13 may be 10 µm. A thickness of the lift-off layer 135 may be 2 to 5 µm. For example, the thickness of the lift-off layer 135 may be 3 µm. A thickness of the metal bridge layer 133 may be 0.1 to 0.4 µm. For example, the thickness of the metal bridge layer 133 may be 0.2 µm. A thickness of the first insulation layer 136 may be 1.0 to 2 µm. For example, the thickness of the first insulation layer 136 may be 1.8 µm. A thickness of each of the first touch electrode 131 and the second touch electrode 132 may be 0.07 to 0.1 µm. For example, the thickness of each of the first touch electrode 131 and the second touch electrode 132 may be 0.08 µm. A thickness of the second insulation layer 137 may be 1.0 to 2 µm. For example, the thickness of the second insulation layer 137 may be 1.8 µm.

In this embodiment of this application, when the flexible display 10 is prepared, as shown in FIG. 11, the touch film layer 13 is provided. For example, the lift-off layer 135 (LLO) is disposed on a substrate 130, and a material of the substrate 130 may be cyclo-olefin polymer (COP). The metal bridge layer 133 is formed on the lift-off layer 135, the lift-off layer 135 and the metal bridge layer 133 are covered with the first insulation layer 136, via holes electrically connected to the metal bridge layer 133 are formed in the first insulation layer 136, the patterned first touch electrode 131 and second touch electrode 132 are formed on the first insulation layer 136, the first touch electrode 131 is electrically connected to the metal bridge layer 133 by using the via hole 134, and the first insulation layer 136, the first touch electrode 131, and the second touch electrode 132 are covered with the second insulation layer 137 to form a touch panel. The touch panel is irradiated by using a laser. Under the action of the laser, a hydrogen bond force between the lift-off layer 135 and the substrate 130 is destroyed. In this way, the substrate 130 lifts off from the lift-off layer 135 along a dashed line in FIG. 11, to obtain the touch film layer 13. The polarizer 14 is fastened to the second insulation layer 137 in the touch film layer 13 by using the second adhesive layer 12b. The display panel 11 is fastened to the lift-off layer 135 in the touch film layer 13 (for example, is fastened to a surface that is of the lift-off layer 135 and that is opposite to the metal bridge layer 133) by using the first adhesive layer 12a, to form the flexible display 10.

It should be noted that a sequence of fastening the polarizer 14 and the display panel 11 to the touch film layer 13 includes but is not limited to the sequence, shown in FIG. 11, in which the polarizer 14 is first fastened and then the display panel 11 is fastened. For example, alternatively, the display panel 11 may be first fastened to the lift-off layer 135 by using the first adhesive layer 12a, and then the polarizer 14 may be fastened to the second insulation layer 137 by using the second adhesive layer 12b.

In a possible implementation, as shown in FIG. 12, the flexible display 10 may further include a protective layer, and the protective layer may include a first protective layer 16 and a second protective layer 17. For example, as shown in FIG. 12, the first protective layer 16 is fastened to the polarizer 14 by using a third adhesive layer 12c, and the second protective layer 17 is fastened to the first protective layer 16 by using a fourth adhesive layer 12d. Materials of the first protective layer 16 and the second protective layer 17 may be PI. Alternatively, a material of the first protective layer 16 may be PI, the second protective layer 17 may be a flexible hard coat (Hard Coat, HC), and materials of the third adhesive layer 12c and the fourth adhesive layer 12d may be optically clear adhesive (OCA) or may be pressure sensitive adhesive (PSA).

In this embodiment of this application, the display panel 11 may be an OLED display panel. For example, as shown in FIG. 12, the display panel 11 may include a flexible substrate 111, a back film 113, and a display layer 115. A fifth adhesive layer 112 is disposed on the flexible substrate 111, the back film 113 is fastened to the flexible substrate 111 by using the fifth adhesive layer 112, a sixth adhesive layer 114 is disposed on a surface that is of the back film 113 and that faces the display layer 115, and the display layer 115 is fastened to the back film 113 by using the sixth adhesive layer 114. The display layer 115 is adhered to the lift-off layer 135 by using the first adhesive layer 12a. The display layer 115 may include a thin film transistor (Thin Film Transistor, TFT) layer and the light-emitting unit (not shown). The light-emitting unit may include a cathode, an anode, and a plurality of organic light-emitting layers (not shown) disposed between the cathode and the anode. The flexible substrate 111 plays a support role, and the back film 113 protects the display layer 115.

A material of the back film 113 may include but is not limited to PI, and materials of the fifth adhesive layer 112 and the sixth adhesive layer 114 may be optically clear adhesive (OCA) or may be pressure sensitive adhesive (PSA).

### Scenario 2

In this embodiment of this application, referring to FIG. 13, the flexible display 10 may further include an adjustment layer 15. The adjustment layer 15 is located between the touch film layer 13 and the first adhesive layer 12a. For example, the touch film layer 13 is disposed on one surface of the adjustment layer 15, and the other surface of the adjustment layer 15 is fastened to the display panel 11 by using the first adhesive layer 12a. In this embodiment of this application, the adjustment layer 15 is included, and the adjustment layer 15 may serve as a neutral layer for adjusting bending of the flexible display 10, to reduce a stress on the touch film layer 13 during bending, so that the touch film layer 13 is not prone to crack in a bending process. Furthermore, a matching degree of temperature and humidity deformation systems of upper and lower layers of the touch film layer 13 may be adjusted by using the adjustment layer 15, to reduce a risk that the touch film layer 13 cracks due to an internal stress when the touch film layer 13 is bent at temperature and humidity. In addition, when the flexible display 10 includes the adjustment layer 15, impact resistance capabilities of the flexible display 10 are increased. In this way, after the flexible display 10 is unfolded, the flexible display 10 is not prone to crack in vertical and horizontal directions under a condition such as an external impact. Therefore, the adjustment layer 15 is disposed, so that the impact resistance capabilities of the flexible display 10 in the vertical and horizontal directions during unfolding are increased.

For example, as shown in FIG. 13, the adjustment layer 15 may include a first adjustment layer 15a and a second adjustment layer 15b. The first adjustment layer 15a is located between the second adjustment layer 15b and the first adhesive layer 12a, and the second adjustment layer 15b is located between the touch film layer 13 and the first adjustment layer 15a. For example, the touch film layer 13 is disposed on the second adjustment layer 15b, the second adjustment layer 15b is located on the first adjustment layer 15a, and the first adjustment layer 15a is located on the first adhesive layer 12a. In this embodiment of this application, the second adjustment layer 15b may isolate a stress for the touch film layer 13, to reduce a stress on the touch film layer 13 during bending (as shown in FIG. 14).

In this embodiment of this application, the second adjustment layer 15b may be a glue layer, for example, may be made of pressure sensitive adhesive (PSA) or optically clear adhesive (OCA). In this way, the second adjustment layer 15b may further adhere the touch film layer 13 to the first adjustment layer 15a. Therefore, in this embodiment of this application, when the second adjustment layer 15b is a glue layer, the second adjustment layer 15b isolates the stress for the touch film layer 13, and fastens the touch film layer 13 to the first adjustment layer 15a.

A material of the first adjustment layer 15a may be an optical material. For example, the optical material may include but is not limited to cyclo-olefin polymer (COP) or polyethylene terephthalate (Polyethylene terephthalate, PET). COP has relatively good light transmission performance. Therefore, in this embodiment of this application, the first adjustment layer 15a is a COP layer. When the first adjustment layer 15a is made of COP, the touch film layer 13 and the first adjustment layer 15a are separated by the second adjustment layer 15b. Therefore, compared with the flexible display in FIG. 8, in this embodiment of this application, the second adjustment layer 15b separates the touch film layer 13 from the COP layer (namely, the first adjustment layer 15a). In this way, the touch electrode in the touch film layer 13 is not prone to an open circuit when the COP layer cracks.

In addition, in this embodiment of this application, the first adjustment layer 15a and the second adjustment layer 15b are disposed between the touch film layer 13 and the display panel 11. In this way, a distance between the touch film layer 13 and the display panel 11 increases, so that noise of a cathode layer in the display panel 11 is prevented from interfering with the touch film layer 13, thereby avoiding crosstalk between the touch film layer 13 and the display panel 11.

In summary, the first adjustment layer 15a and the second adjustment layer 15b are disposed. Therefore, first, a stress adjustment role is implemented, to reduce the stress on the touch film layer 13 during bending; second, a matching degree of temperature and humidity deformation coefficients of the touch film layer 13 is adjusted; third, the impact resistance capabilities of the flexible display 10 in the vertical and horizontal directions during unfolding are increased; and fourth, the crosstalk between the touch film layer 13 and the display panel 11 is avoided.

In some embodiments, when the first adjustment layer 15a is a COP layer and the second adjustment layer 15b is a PSA layer, material Young's moduli of the first adjustment layer 15a and the second adjustment layer 15b are shown in Table 1.

**Table 1**

| Material model | Young's modulus |
|---|---|
| Second adjustment layer 15b: PSA 1# | 800 kPa |
| Second adjustment layer 15b: PSA 2# | 150 kPa |
| Second adjustment layer 15b: PSA 3# | 22 kPa |
| Second adjustment layer 15b: PSA 4# | 80 kPa |
| First adjustment layer 15a: COP | 2.0 GPa |

It may be seen from Table 1 that, when the first adjustment layer 15a is a COP layer and the second adjustment layer 15b is a PSA layer, a Young's modulus of the first adjustment layer 15a is greater than a Young's modulus of the second adjustment layer 15b, and therefore the first adjustment layer 15a is a high Young's modulus layer and the second adjustment layer 15b is a low Young's modulus layer. In this way, a structure including the high Young's modulus layer and the low Young's modulus layer is added between the touch film layer 13 and the display panel 11, to adjust a stress state of the touch film layer 13 to match the temperature and humidity coefficients of the upper and lower layers of the touch film layer 13, thereby improving structural strength of the flexible display 10.

In a possible implementation, as shown in FIG. 13, a thickness h1 of the first adjustment layer 15a may be 20 to 40 µm. For example, the thickness h1 of the first adjustment layer 15a may be 23 µm, or the thickness h1 of the first adjustment layer 15a may be 30 µm. A thickness h2 of the second adjustment layer 15b may be 15 to 25 µm. For example, the thickness h2 of the second adjustment layer 15b may be 18 µm, or the thickness h2 of the second adjustment layer 15b may be 20 µm.

In a possible implementation, for each film layer in the touch film layer 13, refer to the description in the scenario 1. Details are not described in this embodiment of this application again. In this embodiment of this application, referring to FIG. 15, the lift-off layer 135 in the touch film layer 13 is located on the second adjustment layer 15b. When the second adjustment layer 15b is a glue layer, the lift-off layer 135 is fastened to the first adjustment layer 15a by using the second adjustment layer 15b. The lift-off layer 135 and the first adjustment layer 15a are both organic film layers. In this way, when the lift-off layer 135 is adhered to the first adjustment layer 15a, an adhesive force between the lift-off layer 135 and the first adjustment layer 15a increases, so that a binding force between the touch film layer 13 and the first adjustment layer 15a increases, and the touch film layer 13 is not prone to lift off from the first adjustment layer 15a.

When the flexible display 10 provided in this embodiment of this application is prepared, as shown in FIG. 16, the touch film layer 13 may be provided. For example, the lift-off layer 135 (LLO) is disposed on a substrate 130, and a material of the substrate 130 may be cyclo-olefin polymer (COP). The metal bridge layer 133 is formed on the lift-off layer 135, the lift-off layer 135 and the metal bridge layer 133 are covered with the first insulation layer 136, via holes electrically connected to the metal bridge layer 133 are formed in the first insulation layer 136, the patterned first touch electrode 131 and second touch electrode 132 are formed on the first insulation layer 136, the first touch electrode 131 is electrically connected to the metal bridge layer 133 by using the via hole 134, and the first insulation layer 136, the first touch electrode 131, and the second touch electrode 132 are covered with the second insulation layer 137 to form a touch panel. The touch panel is irradiated by using a laser. Under the action of the laser, a hydrogen bond force between the lift-off layer 135 and the substrate 130 is destroyed. In this way, the substrate 130 lifts off from the lift-off layer 135 along a dashed line in FIG. 16, to obtain the touch film layer 13. The polarizer 14 is fastened to the second insulation layer 137 in the touch film layer 13 by using the second adhesive layer 12b. The second adjustment layer 15b is made of PSA, and therefore the first adjustment layer 15a is fastened to the lift-off layer 135 (for example, is fastened to a surface that is of the lift-off layer 135 and that faces the display panel 11) by using the second adjustment layer 15b. The display panel 11 is fastened to the first adjustment layer 15a (for example, is fastened to a surface that is of the first adjustment layer 15a and that faces the display panel 11) by using the first adhesive layer 12a, to form the flexible display 10.

It should be noted that a sequence of disposing the touch film layer 13, the polarizer 14, the display panel 11, and the adjustment layer 15 includes but is not limited to the preparation sequence shown in FIG. 11. For example, alternatively, the adjustment layer 15 may be fastened to the display panel 11 by using the first adhesive layer 12a, and then a structure formed by the display panel 11 and the adjustment layer 15 is fastened to the lift-off layer 135 by using the first adjustment layer 15a; and the polarizer 14 is fastened to the second insulation layer 137 in the touch film layer 13 by using the second adhesive layer 12b.

In a possible implementation, the flexible display 10 may further include a first protective layer 16 and a second protective layer 17. For example, as shown in FIG. 17, the first protective layer 16 is fastened to the polarizer 14 by using a third adhesive layer 12c, and the second protective layer 17 is fastened to the first protective layer 16 by using a fourth adhesive layer 12d. Materials of the first protective layer 16 and the second protective layer 17 may be PI. Alternatively, a material of the first protective layer 16 may be PI, the second protective layer 17 may be a flexible hard coat (Hard Coat, HC), and materials of the third adhesive layer 12c and the fourth adhesive layer 12d may be optically clear adhesive (OCA) or may be pressure sensitive adhesive (PSA).

In this embodiment of this application, the display panel 11 may be an OLED display panel 11. For example, as shown in FIG. 17, the display panel 11 may include a flexible substrate 111, a back film 113, and a display layer 115. A fifth adhesive layer 112 is disposed on the flexible substrate 111, the back film 113 is fastened to the flexible substrate 111 by using a sixth adhesive layer 114, a sixth adhesive layer 114 is disposed on a surface that is of the back film 113 and that faces the display layer 115, and the display layer 115 is fastened to the back film 113 by using the sixth adhesive layer 114. The display layer 115 is adhered to the lift-off layer 135 by using the first adhesive layer 12a. The display layer 115 may include a thin film transistor (Thin Film Transistor, TFT) layer and the light-emitting unit. The light-emitting unit may include a cathode, an anode, and a plurality of organic light-emitting layers disposed between the cathode and the anode.

Based on the foregoing description, in this embodiment of this application, a simulation test is performed on maximum principal strains (there is a positive correlation between a maximum principal strain and a stress, for example, a greater maximum principal strain indicates a greater stress) of each film layer in the flexible display 10 in the scenario 1 and the scenario 2 during bending. A test result is shown in FIG. 18 and FIG. 19. In the flexible display 10, the second protective layer 17 is made of PI, the fourth adhesive layer 12d is made of OCA, the first protective layer 16 is made of PI, the third adhesive layer 12c is made of OCA, the polarizer 14 is a circular polarizer 14, the second adhesive layer 12b is made of PSA, the second adjustment layer 15b is made of PSA (with a Young's modulus of 800 kPa), the first adjustment layer 15a is made of COP, the first adhesive layer 12a is made of PSA, the sixth adhesive layer 114 is made of OCA, the back film 113 is made of PI, and the fifth adhesive layer 112 is made of OCA.

It may be seen from FIG. 18 that, during bending, each adhesive layer suffers a greater stress. A stress on each adhesive layer in the scenario 2 is less than a stress on each adhesive layer in the scenario 1. Therefore, in the scenario 2, the adjustment layer 15 is disposed, and the adjustment layer 15 serves as a neutral layer for bending adjustment, to reduce the stress on each adhesive layer.

It may be seen from FIG. 19 that during bending, a stress on the touch film layer 13 in the scenario 2 is less than a stress on the touch film layer 13 in the scenario 1. Therefore, the adjustment layer 15 is disposed, and the adjustment layer 15 plays a stress adjustment role, to reduce the stress on the touch layer in the bending process. It is learned from FIG. 19 that, compared with that of the touch film layer 13 in the scenario 1, a maximum principal strain of the touch film layer 13 during bending in the scenario 2 decreases by about 30%. Therefore, when the flexible display 10 provided in this embodiment of this application is bent, the stress on the touch film layer 13 is reduced by using the adjustment layer 15, thereby reducing a risk that the touch film layer 13 cracks in the bending process.

In the description of the embodiments of this application, it should be noted that, unless otherwise specified and limited, the terms "install", "connect", and "connected" should be understood in a broad sense, for example, may indicate a fixed connection, or may be an indirect connection performed by using an intermediate medium, or may be an interconnection between two elements or an interaction relationship between two elements. For persons of ordinary skill in the art, specific meanings of the terms in the embodiments of this application may be understood based on specific situations.

In the specification, claims, and accompanying drawings of the embodiments of this application, the terms "first", "second", "third", "fourth", and the like (if existent) are intended to distinguish between similar objects but do not necessarily indicate a specific order or sequence.

Finally, it should be noted that the foregoing embodiments are merely intended for describing the technical solutions of the embodiments of this application rather than limiting this application. Although the embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of this application.

## Claims

1. A flexible display, comprising:
at least a display panel, a first adhesive layer, a first adjustment layer, a second adjustment layer, and a touch film layer that are laminated, wherein the first adhesive layer is located between the display panel and the first adjustment layer, and the second adjustment layer is located between the first adjustment layer and the touch film layer; and
the first adjustment layer is a cyclo-olefin polymer COP layer, and the second adjustment layer is a glue layer.

2. The flexible display according to claim 1, wherein a Young's modulus of the first adjustment layer is greater than a Young's modulus of the second adjustment layer.

3. The flexible display according to claim 2, wherein the Young's modulus of the first adjustment layer is 2.0 GPa and the Young's modulus of the second adjustment layer is 80 to 800 kPa.

4. The flexible display according to any one of claims 1 to 3, wherein a thickness of the first adjustment layer is 20 to 40 µm.

5. The flexible display according to any one of claims 1 to 4, wherein a thickness of the second adjustment layer is 15 to 25 µm.

6. The flexible display according to any one of claims 1 to 5, wherein the glue layer is made of pressure sensitive adhesive PSA or optically clear adhesive OCA.

7. A flexible display, comprising:
at least a display panel, a first adhesive layer, and a touch film layer that are laminated, wherein the first adhesive layer is located between the touch film layer and the display panel.

8. The flexible display according to any one of claims 1 to 7, wherein the touch film layer comprises a lift-off layer, a metal bridge layer disposed on the lift-off layer, a first insulation layer disposed on the lift-off layer and the metal bridge layer, a first touch electrode and a second touch electrode that cross and are insulated mutually and that are disposed on the first insulation layer, and a second insulation layer disposed on the first insulation layer, the first touch electrode, and the second touch electrode; and
one of the first touch electrode and the second touch electrode is disconnected at a cross position and connected by using the metal bridge layer.

9. The flexible display according to any one of claims 1 to 8, further comprising a polarizer and a second adhesive layer, wherein the second adhesive layer is located between the polarizer and the touch film layer.

10. The flexible display according to claim 9, further comprising a protective layer and a third adhesive layer, wherein the third adhesive layer is located between the protective layer and the second adhesive layer.

11. An electronic device, comprising at least the flexible display according to any one of claims 1 to 10, a middle frame, and a rear housing, wherein the middle frame is located between the flexible display and the rear housing.

12. The electronic device according to claim 11, wherein the electronic device is a foldable electronic device.

13. The electronic device according to claim 12, wherein the middle frame comprises at least a first middle frame and a second middle frame, and the first middle frame and the second middle frame are rotatably connected by using a rotating member.

14. The electronic device according to claim 11, wherein the flexible display is a rollable display with two ends rolled toward the rear housing.

15. A flexible display preparation method, wherein the method comprises:
providing a touch film layer, a display panel, a first adjustment layer, a second adjustment layer, and an adhesive layer, wherein the first adjustment layer is a cyclo-olefin polymer COP layer, and the second adjustment layer is a glue layer;
disposing the second adjustment layer between the touch film layer and the first adjustment layer; and
disposing the adhesive layer between the first adjustment layer and a light-emitting surface of the display panel to form a flexible display.

16. The preparation method according to claim 15, wherein the providing a touch film layer comprises:
forming a lift-off layer on a substrate;
forming a metal bridge layer on the lift-off layer;
disposing a first insulation layer on the lift-off layer and the metal bridge layer, and forming, in the first insulation layer, via holes each with one end electrically connected to the metal bridge layer;
forming, on the first insulation layer, a first touch electrode and a second touch electrode that cross and are insulated mutually, wherein one of the first touch electrode and the second touch electrode is disconnected at a cross position and connected to the metal bridge layer by using the via hole;
disposing a second insulation layer on the first touch electrode, the second touch electrode, and the first insulation layer; and
separating the substrate from the lift-off layer to form the touch film layer.

17. The preparation method according to claim 15 or 16, wherein the disposing the second adjustment layer between the touch film layer and the first adjustment layer comprises:
forming the second adjustment layer on the first adjustment layer; and
disposing the touch film layer on a surface that is of the second adjustment layer and that is opposite to the first adjustment layer.

18. The preparation method according to any one of claims 15 to 17, wherein the disposing the adhesive layer between the first adjustment layer and a light-emitting surface of the display panel comprises:
forming the adhesive layer on the light-emitting surface of the display panel; and
adhering the first adjustment layer to the adhesive layer to form the flexible display; or
forming the adhesive layer on a surface that is of the first adjustment layer and that faces the display panel; and
adhering the light-emitting surface of the display panel to the adhesive layer to form the flexible display.

19. A flexible display preparation method, wherein the method comprises:
providing a touch film layer, a display panel, and an adhesive layer; and
disposing the adhesive layer between the touch film layer and a light-emitting surface of the display panel to form a flexible display.

20. The preparation method according to claim 19, wherein the providing a touch film layer comprises:
forming a lift-off layer on a substrate;
forming a metal bridge layer on the lift-off layer;
disposing a first insulation layer on the lift-off layer and the metal bridge layer, and forming, in the first insulation layer, via holes each with one end electrically connected to the metal bridge layer;
forming, on the first insulation layer, a first touch electrode and a second touch electrode that cross and are insulated mutually, wherein one of the first touch electrode and the second touch electrode is disconnected at a cross position and connected to the metal bridge layer by using the via hole;
disposing a second insulation layer on the first touch electrode, the second touch electrode, and the first insulation layer; and
separating the substrate from the lift-off layer to form the touch film layer.

21. The preparation method according to claim 20, wherein the disposing the adhesive layer between the touch film layer and a light-emitting surface of the display panel comprises:
forming the adhesive layer on the light-emitting surface of the display panel; and
adhering the lift-off layer in the touch film layer to the adhesive layer to form the flexible display; or
forming the adhesive layer on a surface that is of the lift-off layer and that is opposite to the first insulation layer; and
adhering the light-emitting surface of the display panel to the adhesive layer to form the flexible display.

22. A program product, wherein the program product comprises a computer program, the computer program is stored in a readable storage medium, at least one processor of a communications apparatus can read the computer program from the readable storage medium, and the at least one processor executes the computer program to enable the communications apparatus to implement the method according to any one of claims 15 to 18 or the method according to any one of claims 19 to 21.
